# FASCICULE DE BREVET EUROPEEN

(11) **EP 2 891 395 B1**
(45) Date de publication et mention de la délivrance du brevet: **03.07.2019**
(21) Numéro de dépôt: 13762178.5
(22) Date de dépôt: 22.08.2013
(51) Int. Cl.: B63C 11/04, B63C 11/08, F04D 13/08, H02J 7/00, B63C 11/02, H02J 50/10, H05K 5/06

(54) **DISPOSITIF ELECTRONIQUE POUR EQUIPEMENT DE PLONGEE**
ELEKTRONISCHE VORRICHTUNG FÜR TAUCHAUSRÜSTUNG
ELECTRONIC DEVICE FOR DIVING EQUIPMENT

(30) Priorité: 28.08.2012 FR 1258024
(43) Date de publication de la demande: 08.07.2015
(73) Titulaire: Letsact, 78860 Saint Nom la Breteche (FR)
(72) Inventeur: CASTELLANET, Frédéric, F-75002 Paris (FR)
(74) Mandataire: Mazabraud, Xavier
(86) Numéro de dépôt international: PCT/FR2013/051955
(87) Numéro de publication internationale: WO 2014/033391

(56) Documents cités:
- DE-A1- 19 914 380
- DE-U1-202011 101 153
- US-A1- 2012 132 207
- US-B1- 6 694 911

## Description

L'invention se situe dans le domaine des dispositifs électroniques devant fonctionner en milieu agressif, notamment le milieu marin, applicables notamment aux équipements de plongée.

Certaines activités nécessitent l'utilisation de dispositifs électroniques en milieu marin, par exemple des équipements de plongée. Or l'eau de mer est un milieu très conducteur et il est indispensable d'éviter tout contact entre l'électronique et l'eau de mer.

Les documents US 6 694 911 B1 (Gallagher Dennis et Al), DE 199 14 380 A1 (Appel Peter), DE 20 2011 101153 U1 (Wika Alexander Wiegand SE & Co KG) et US 2012/132207 A1((Straw Philip Edward) décrives des solutions imparfaites à ce problème.

Une solution connue pour mettre un circuit électronique à l'abri de l'eau de mer est de l'enfermer dans un conteneur ou boîtier étanche et d'utiliser des connecteurs étanches pour les câbles de liaison. Cependant une étanchéité absolue et permanente, aussi bien pour le conteneur que les connecteurs, est difficile à garantir. De plus, le conteneur a un volume et une masse difficilement compatibles avec une activité individuelle telle que la plongée.

L'invention se propose de résoudre ces difficultés. A cet effet, elle propose un dispositif pour plongeur selon la revendication 1 comportant au moins un circuit électronique et une batterie prévue pour alimenter ledit circuit, dans lequel le circuit et la batterie sont inclus dans un bloc de matériau hydrophobe.

Un matériau hydrophobe est insensible à l'eau, non conducteur et non oxydable. Le bloc d'inclusion peut être constitués d'au moins deux coquilles appliquées l'une sur l'autre et comportant un joint d'étanchéité en périphérie, ce qui permet d'ouvrir le dispositif et de réaliser une intervention sur le circuit ou la batterie, mais avantageusement il s'agit d'un monobloc.

Le dispositif comporte en outre au moins un actionneur inclus dans ledit bloc de matériau hydrophobe, commandé par lédit circuit électronique et alimenté par ladite batterie.

En termes généraux, un actionneur est un organe capable d'exécuter un travail ordonné par une unité de commande distante. Des exemples d'actionneurs sont un moteur électrique, un vérin, un électroaimant, une céramique piézoélectrique...

La plupart des actionneurs étant sensibles à l'eau de mer, il est particulièrement avantageux que le ou les actionneurs utilisés dans l'invention soient également inclus dans le bloc de matériau hydrophobe.

Avantageusement, le bloc de matériau hydrophobe peut être un bloc de résine, par exemple une résine bi-composant polymérisable à l'aide d'un composant durcisseur. Les résines polymérisables sont connues pour leur insensibilité à l'eau.

L'avantage d'un bloc de résine polymérisée est également son faible poids (poids relatif quasi nul dans l'eau de mer) et son faible encombrement.

Lorsque le circuit électronique est noyé dans un bloc de résine il n'est plus possible d'intervenir dessus, en revanche la résine n'étant pas conductrice, il reste possible de reprogrammer un micro-processeur ou de remplir une mémoire par ondes électromagnétiques ou bien par liaison optique.

Avantageusement, la batterie peut être du type à recharge sans contact électrique, notamment une batterie à recharge par induction.

On évite ainsi les prises métalliques du type pour chargeur externe qui sont susceptibles de créer des entrées d'eau et des courts circuits. Du fait que la batterie est incluse dans le bloc de matériau hydrophobe, on évite également les entrées d'eau qui pourraient se produire dans un compartiment de batteries insuffisamment étanche.

Avantageusement, le dispositif peut comporter en outre un panneau de commande.

Ce panneau de commande constitue un moyen de dialogue entre le dispositif et le plongeur. Il peut se situer sur le dispositif lui-même ou de préférence être déporté du bloc de matériau hydrophobe.

Avantageusement, le dispositif peut comporter en outre des moyens de communication entre ledit circuit électronique et ledit panneau de commande.

Lorsque le panneau de commande est distinct du bloc de matériau hydrophobe, il est avantageux que le dispositif comporte des moyens de communication entre eux, permettant de transmettre des informations et/ou de recevoir des commandes du plongeur, ces moyens de communication étant disposés en surface ou à l'intérieur du bloc et du panneau.

Lorsqu'il est déporté du bloc, le panneau de commande se porte par exemple au poignet du plongeur.

Avantageusement, les moyens de communication peuvent comporter au moins un moyen d'émission/réception de signaux optiques et/ou radio et/ou d'ondes acoustiques.

Ces moyens de communication sont insensibles à l'eau de mer. L'eau de mer étant un milieu conducteur, les ondes radio ne s'y propagent pas bien, mais sur de courtes distances certaines fréquences radio, comprises entre 30 et 40 kHz, peuvent être utilisées.

Avantageusement, les moyens d'émission/réception de signaux optiques peuvent comporter au moins une prise optique prévue pour y brancher un câble à fibres optiques.

Des signaux optiques peuvent se propager dans l'eau sur de courtes distances, mais il est préférable d'utiliser des câbles à fibres optiques pour transporter ces signaux.

Le dispositif ne comporte donc pas de prises métalliques et/ou électriques pour l'émission et la réception de signaux de l'extérieur mais des prises optiques, procurant des moyens de connexion aux prises d'extrémité de câbles optiques et ne comportant pas de contact électrique.

Le dispositif selon l'invention est donc intrinsèquement insensible à l'eau :
- Le circuit électronique est entièrement entouré par le matériau qui le met à l'abri des agressions du milieu marin,
- La batterie se recharge par induction ; de ce fait, il n'existe pas sur le dispositif de prise pour le branchement d'un chargeur, qui pourrait constituer une entrée d'eau,
- Les entrées et sorties de signaux (commandes, valeurs de mesure...) se font par l'intermédiaire de fibres optiques connectées sur le bloc de matériau ou d'ondes radio ; il ne comporte pas de prise pour le branchement câbles électriques qui comporteraient à leur extrémité un connecteur étanche.

Avantageusement le dispositif peut comporter en outre un capteur de pression et/ou de température.

Ces capteurs sont intégrés au bloc de résine de façon à ne pas constituer une porte d'entrée pour l'eau de mer dans le dispositif. Le capteur de pression sera utile dans des applications de stabilisation en immersion décrites plus loin.

Avantageusement, l'actionneur du dispositif peut comporter au moins un moteur entraînant un compresseur, ledit compresseur comprenant une canalisation au sein dudit bloc de matériau, le rotor dudit moteur étant logé à l'intérieur de ladite canalisation, le stator étant noyé dans ledit bloc de matériau.

Dans une application à la stabilisation en immersion du plongeur, le dispositif électronique peut être utilisé pour gonfler ou dégonfler un sac de gaz, la commande correspondante ayant été fournie grâce au panneau de commande décrit plus haut. Dans ce cas, il est avantageux qu'un moteur entraînant un compresseur, par exemple un compresseur à vis, soit intégré au bloc de résine du dispositif. Un tel compresseur peut alors comprendre une canalisation au sein du bloc de résine, destinée à recevoir le gaz à entraîner, ce gaz étant conduit par des conduites connectées de façon étanche au bloc de résine. Le moteur peut comprendre un rotor au sein de cette canalisation, pour entraîner le gaz, ce rotor étant entraîné en rotation par un stator noyé dans le bloc de résine et alimenté en énergie par la batterie du dispositif électronique. Ce compresseur étant prévu pour mettre en circulation de l'air respirable, il devra s'agir d'un compresseur sans huile.

L'actionneur comporte une vanne ou un clapet prévu pour être commandé à distance.

Si le gaz utilisé pour gonfler un sac de stabilisation est fourni par une bouteille de gaz sous pression, il suffit que la bouteille et le sac soient connectés au dispositif et qu'une vanne ou un clapet dont l'ouverture et la fermeture peuvent être commandées à distance par le circuit électronique, par exemple motorisé, inclus dans le bloc de résine autorise le passage du gaz en s'ouvrant.

L'invention porte également sur un gilet de stabilisation à air perdu pour plongeur, comportant un dispositif selon l'invention relié d'une part à une bouteille de gaz de respiration et d'autre part à au moins un sac dudit gilet de stabilisation par des canalisations de gaz.

On rappelle qu'un gilet de stabilisation pour plongeur (ou «Stab») permet au plongeur de régler son immersion et/ou sa vitesse de descente ou de remontée : en descente, arrivé à la profondeur souhaitée, le plongeur gonfle légèrement le/les sacs de sa « Stab » pour s'équilibrer à cette profondeur. Par la suite, le gonflage de la « Stab » provoque la remontée du plongeur et son dégonflage stoppe cette remontée.

La « Stab » se gonfle soit à la bouche, soit en puisant dans la bouteille d'air comprimé de respiration lorsque la « Stab » est directement relié à la bouteille. Elle fonctionne alors en air perdu, car lors du dégonflage du/des sac(s) le gaz s'échappe dans l'eau.

Le dispositif comporte un capteur de pression et au moins un compresseur ou une vanne motorisée, relié par des conduites de gaz étanches d'une part à la bouteille de gaz de respiration, munie d'un détendeur, et d'autre part à au moins un sac de gaz d'un gilet de stabilisation. Si le gilet comporte plusieurs sacs groupés à des emplacements du gilet (par exemple au niveau de la poitrine du plongeur, de son dos, de ses épaules), il sera avantageux que le dispositif comporte un compresseur par groupe de sacs (par exemple un compresseur pour les sacs de devant, un pour les sacs de derrière, un pour les sacs d'épaules), de façon à individualiser le gonflage des sacs en fonction de la position du plongeur ou de la commande ; par exemple, les sacs situés au niveau des épaules de l'utilisateur lui assurent une remontée en position verticale.

Plus simplement, le passage de l'air de la bouteille d'air comprimé vers les sacs peut se faire par une vanne ou un clapet motorisé.

Les sacs n'ont pas besoin d'être munis de clapets, les compresseurs ou vannes étant conçus pour maintenir l'étanchéité des sacs.

Dans le sens vidage des sacs, l'air s'échappe des compresseurs par une soupape. Il est nécessaire que l'air puisse s'échapper des sacs dans toutes les positions du plongeur, notamment tête en bas. A cet effet, il est avantageux que des moyens d'évacuation de l'air soient disposés à chaque coin des sacs. Par exemple, la conduite d'évacuation de l'air peut parcourir la paroi interne du sac et être munie d'ouvertures de long d'une ou plusieurs génératrices.

L'invention porte également sur un gilet de stabilisation à air recyclé pour plongeur, pouvant comporter un dispositif selon l'invention, relié d'une part à une bouteille de gaz pour la stabilisation et d'autre part à au moins un sac dudit gilet de stabilisation par des canalisations de gaz.

Dans ce cas le gaz utilisé pour la stabilisation n'est pas pris sur la bouteille de gaz destiné à la respiration, il provient d'une bouteille spécifique ; de plus il n'est pas perdu lors du dégonflage du/des sac(s), il est renvoyé vers cette bouteille spécifique grâce au compresseur. Il s'agit dans ce cas d'une petite bouteille, par exemple d'un demi-litre, gonflée à une pression bien plus basse que celle de la bouteille d'air de respiration, compatible avec la puissance du compresseur, par exemple 20 bars.

Avantageusement, dans cette application à la stabilisation, le panneau de commande du dispositif du gilet de stabilisation peut comporter un interrupteur optique pour activer/désactiver une fonction Stabilisation à l'immersion atteinte du dispositif.

Avantageusement, le panneau de commande peut comporter en outre au moins un interrupteur optique pour activer/désactiver respectivement au moins l'une des fonctions suivantes du dispositif :
- Montée lente,
- Montée rapide,
- Descente lente,
- Descente rapide,
- Pause.

On entend par interrupteur optique un dispositif de commande comportant au moins deux fibres optiques, disposées dans ce dispositif de telle sorte que la transmission de la lumière ne se fait d'une fibre à l'autre que lorsqu'un objet est appliqué sur l'interrupteur. «Au repos » l'interrupteur est ouvert, il ne se ferme que lorsqu'un objet (par exemple le doigt du plongeur) est appliqué, provoquant la transmission au dispositif électronique de la commande associée à cet interrupteur. De façon alternative, on peut prévoir qu'au repos l'interrupteur est fermé et que le doigt de l'utilisateur ouvre le circuit optique.

Pour éviter les fausses manoeuvres, on peut prévoir que la commande ne s'exécute que si l'utilisateur maintient son doigt un certain temps sur l'interrupteur, par exemple une seconde, ou confirme sa commande par une deuxième application de son doigt, soit sur le même interrupteur, soit sur un interrupteur de validation. On peut prévoir également que l'exécution de la commande soit signalée par un changement de couleur de l'interrupteur optique.

En fonction des consignes données par le plongeur par l'intermédiaire de ces interrupteurs optiques, le dispositif contrôle soit la profondeur d'immersion soit la vitesse de montée ou de descente du plongeur.

Ceci permet de soulager le plongeur d'avoir à surveiller son immersion ou sa vitesse de descente ou de remontée, il donne ses consignes par le biais du panneau de commande. La consigne ainsi que la valeur de la pression à laquelle se trouve le plongeur sont traitées par le circuit électronique qui commande les moteurs des compresseurs ou les vannes. Le contrôle exercé par un dispositif électronique est avantageux, il permet par exemple d'éviter de dépasser une profondeur ou une vitesse de remontée limite.

Bien sûr, le plongeur doit avoir, tout équipé, une flottabilité légèrement négative lorsque les sacs sont vides (c'est-à-dire qu'il doit avoir tendance à descendre), cette flottabilité étant réglée par des lests en plomb, ces lests pouvant prendre place dans des poches adaptées du gilet.

La fonction Pause consiste en la mise en pause du système de régulation de la profondeur, le plongeur maintient lui-même sa profondeur d'immersion, par exemple en inspirant, ce qui le fait légèrement remonter, soit en expirant, ce qui le fait légèrement descendre.

L'invention porte également sur un recycleur à circuit fermé pour plongeur comportant un dispositif selon l'invention.

Dans une application aux respirateurs à circuit fermé, le dispositif mesure et contrôle la pression partielle en oxygène du mélangé respiré par le plongeur et règle l'admission d'oxygène pur de façon que cette pression partielle reste dans une fourchette acceptable.

Des modes de réalisation et des variantes seront décrits ci-après, à titre d'exemples non limitatifs, avec référence aux dessins annexés dans lesquels :
La figure 1 représente schématiquement un dispositif selon l'invention,
La figure 2 représente schématiquement le buste d'un plongeur équipé d'un gilet de plongée en circuit fermé, vu de face,
Les figures 3 et 4 représentent schématiquement le gilet de plongée, vu de dos,
La figure 5 représente une vue agrandie du panneau de commande de stabilisation et de montée / descente.

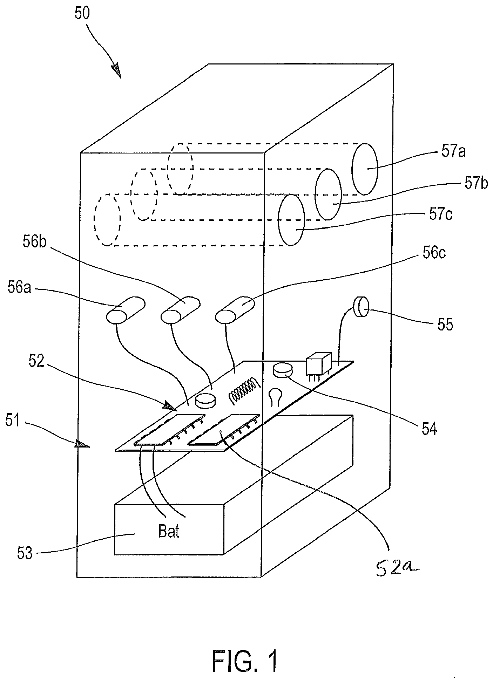

La figure 1 illustre un dispositif électronique 50 selon l'invention. Le dispositif 50 comporte, noyés dans un bloc de résine 51 et vus en transparence à l'intérieur de ce bloc :
- Un circuit électronique 52 de conception classique, monté sur une carte électronique ; la constitution détaillée de ce circuit électronique dépend de la fonction remplie par le dispositif, mais il comprend généralement au moins un microprocesseur 52a,
- Une batterie 53 à recharge par induction, prévue pour alimenter le dispositif en électricité
- Un capteur de pression 54 relié au circuit électronique 52, dont le senseur n'a pas besoin d'être au contact de l'eau car la résine transmet la pression à ce senseur, il peut être monté directement sur la carte électronique,
- Un capteur de température 55 relié au circuit électronique 52, dont le senseur est avantageusement placé à proximité d'une face du bloc de résine, à l'intérieur de ce bloc, pour éviter tout contact entre le capteur et l'eau de mer,
- Des prises optiques 56a, 56b, 56c débouchant sur une face du bloc de résine 51 et reliées par fibre optique au circuit électronique 52 ; de façon alternative, on peut prévoir que des câbles à fibres optiques émanent directement du bloc de résine 51,
- Des compresseurs, vannes ou clapets logés dans des canalisations 57a, 57b, 57c qui traversent le bloc de résine 51.

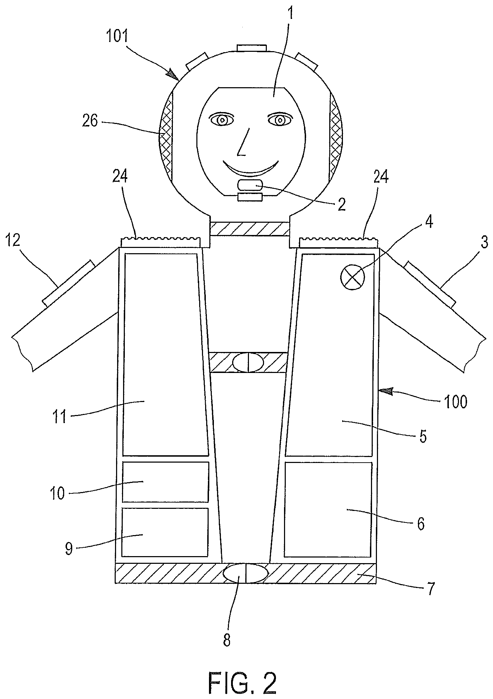

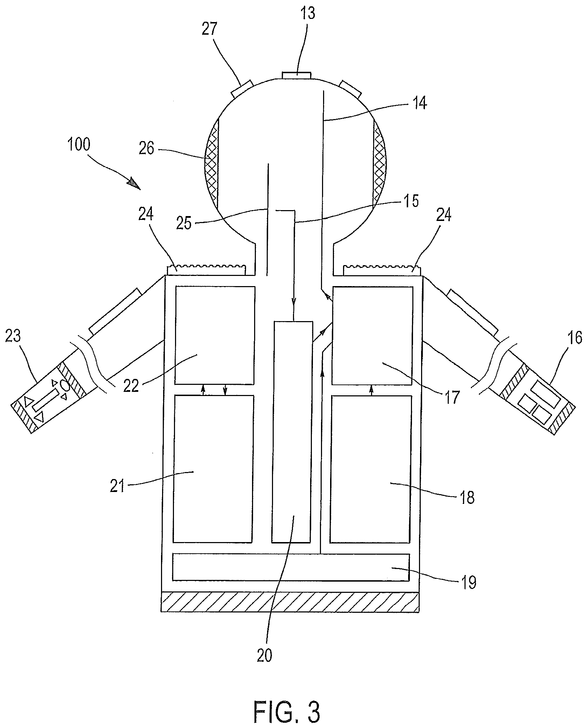

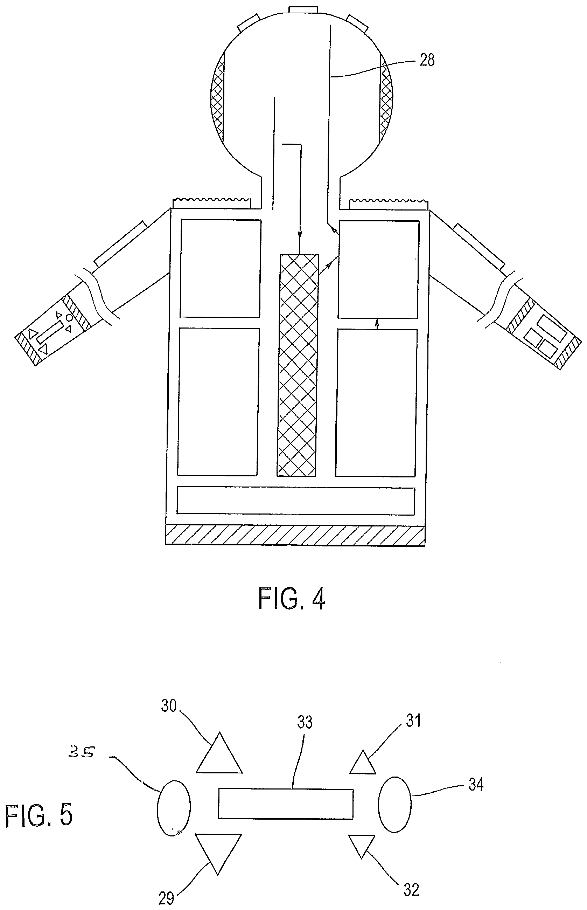

Les figures 2 à 5 illustrent deux applications d'un dispositif électronique selon l'invention à un gilet de plongée.

### Equipement de base : le gilet pour plongée à recyclage

Le gilet selon l'invention 100 comporte au moins deux dispositifs électroniques de commande comme décrits plus haut, l'un pour la stabilisation en immersion, l'autre pour le recycleur en circuit fermé, chacun comportant un circuit électronique et une batterie inclus dans un bloc de résine.

Le gilet s'enfile comme un blouson de ville normal mais il se caractérise par des poches, chacune renfermant soit une bouteille de gaz, soit un sac gonflable, soit un dispositif électronique, soit encore un sac renfermant un absorbant de CO₂. Il peut comporter en plus un casque 101.

Le gilet est parcouru d'un réseau de fibres optiques et d'un réseau de conduites de gaz flexibles. Les fibres optiques font circuler des informations et les conduites un mélange respirable jusqu'à 4 bars.

Le gilet comporte des poches ouvertes et des poches fermées, par exemple par collage ou soudage.

Les poches ouvertes du gilet renferment :
- Dans le dos, un dispositif électronique 17, une bouteille d'oxygène pur 19 à 200 bars de 3 litres environ, un sac souple d'absorbant de CO₂ 20, par exemple de chaux, la chaux étant à changer régulièrement,
- Sur le devant du gilet, un ensemble de secours 6 comprenant une bouteille d'air comprimé avec détendeur pour alimenter l'embout 2 du casque en secours.

Les poches fermées sont protégées par du kevlar ou un autre tissu indéchirable, elles contiennent :
- sur le devant du gilet, un faux poumon 5 du recycleur à circuit fermé, et à hauteur de la poitrine, un sac d'équilibrage 11 permettant la montée / descente et la stabilisation
- sur les épaules des sacs 24 permettant la remontée.

### Fonction stabilisation et montée-descente.

Dans une plongée classique le plongeur monte et descend en gonflant et dégonflant manuellement un sac stabilisateur (ou «stab») et affine son immersion en gonflant et dégonflant ses poumons (poumons ballast). Ici comme le plongeur ne rejette pas d'air, la manoeuvre de poumon ballast est inopérante. L'ensemble est donc remplacé par des sacs gonflables logés dans des poches fermées du gilet.

Quatre sacs gonflables sont placés à hauteur de la poitrine, deux devant, deux derrière (un seul, référence 11, est représenté) pour stabiliser l'immersion et pour la montée ou la descente.

De plus, deux sacs gonflables 24 destinés à donner un supplément de portance pour la montée rapide sont placés sur les épaules. Ils sont placés sur les épaules pour forcer le plongeur inexpérimenté à bien remonter avec la tête en haut.

Un panneau de commande 23 comportant les boutons de commande sous la forme d'interrupteurs optiques de stabilisation et de montée / descente 29 à 34 est placé sur le poignet gauche. Il est relié au dispositif électronique de stabilisation et de montée / descente 22 par des câbles à fibres optiques de façon à ne pas avoir de circulation de courant électrique.

Deux compresseurs sont placées dans le dispositif électronique de montée / descente 22 permettant de faire communiquer à volonté de l'air provenant d'une ou plusieurs bouteille(s) d'air comprimé à 20 bars 21 et les sacs gonflables 11, 24 sous pression locale. Ces compresseurs sont noyés dans la même résine que le circuit électronique de commande et la batterie. De cette manière il n'y a aucun connecteur électrique au contact de l'eau. La batterie est rechargée par induction pour cette même raison.

Pour des raisons de sécurité tout le matériel est doublé : le réseau de fibre optique montée / descente rapide est séparé du réseau montée / descente lent. Les systèmes électroniques sont aussi doublés avec un système maître comme dans l'industrie spatiale. L'ensemble des systèmes de conduites et réseau de fibres sont protégés des chocs et déchirures par un tissus « indéchirable » type kevlar ou des coques en métal.

L'ordre de montée / descente lent ne gonfle que les sacs d'équilibrage situés au niveau des poumons. L'ordre de montée / descente rapide gonfle en plus les sacs 24 situés au niveau des épaules. Cela permet d'avoir deux circuits totalement indépendants et si un réseau de montée tombe en panne, l'autre qui est valide permet de remonter doucement.

Les commandes optiques comportent un réseau de conduite de lumière qui illumine en permanence les boutons. Deux fonctionnements sont envisagés : lorsque l'on approche le doigt, soit cela réfléchit une partie de la lumière dans une autre fibre qui envoie l'ordre, soit cela coupe le circuit lumineux entre deux fibres et c'est cette coupure qui donne l'ordre.

### Equilibrage des oreilles.

Lors de la descente, la pression de l'eau sur la face extérieure du tympan augmente et s'écarte de la pression sur la face intérieure ce qui peut occasionner une douleur intense. Pour équilibre les oreilles on procède alors par exemple à la « manoeuvre de Valsalva » : on se pince le nez et on souffle fort dedans ce qui équilibre la pression de part et d'autre du tympan et on recommence cette manoeuvre durant toute la descente.

Pour éviter l'apprentissage de cette manoeuvre et pour pouvoir faire un masque plus grand, le casque du gilet incorpore deux petits sacs gonflables 26 sur les oreilles. Réaliser des cycles de pression dépression dans ces sacs permet d'aider à l'équilibrage des oreilles. Ces cycles peuvent être créés par un petit vérin ou une membrane souple dans le circuit d'air. On prendra soin de rester hors de la zone audible (20 Hz - 20 000 Hz). Ces sacs gonflables sont commandés par un bouton spécifique 35 du panneau de commande 23.

### Fonction recycleur à circuit fermé

Le principe de base du gilet selon l'invention est celui de la plongée à recycleur à circuit fermé. L'air expiré par le plongeur est envoyé dans un sac 20 d'absorbant qui absorbe le CO₂ et laisse passer le dioxygène non utilisé. L'absorbant de CO₂ (chaux ou autre) est contenu dans un sac souple 20 logé le long de la colonne vertébrale. De cette façon les mouvements du plongeur malaxent la chaux empêchant la création de passages préférentiels.

Un complément d'oxygène pur contenu dans une petite bouteille 19 est ajouté à l'air ayant franchi le sac d'absorbant. La pression partielle d'oxygène dans le mélange est contrôlée en permanence grâce à des capteurs et au dispositif électronique 17 dédié à cette fonction.

Le pourcentage d'oxygène est calculé en fonction de la profondeur mais également en fonction de l'état du plongeur, notamment son pouls ou une autre donnée physiologique dénotant un état de manque (pupille...) ou de l'indication de remontée d'urgence.

L'usage d'un casque englobant la bouche et le nez dans lequel on établit et régule un flux d'air adapté à la profondeur et la température rend non seulement l'usage plus facile pour un plongeur débutant mais permet aussi d'éviter de rajouter au système une capacité tampon.

Toutes les données sur l'état physiologique et les compositions gazeuses sont amenées par des fibres optiques. Pour cela on logera les diodes de mesure (% d'oxygène par diode laser notamment...) dans le dispositif électronique comprenant l'électronique et la batterie de façon à ce qu'aucun courant ou signal électrique ne circule en dehors du bloc de résine.

Toute l'électronique et les capteurs sont doublés avec un processeur maître pour déterminer à quel système faire confiance. Les réseaux de fibre optique et de conduites des dispositifs électroniques 17 et 22 sont protégés des déchirures par du kevlar ou équivalent.

### Panneau d'information sur la plongée 16

Les informations sur l'état de la plongée sont générées par un dispositif électronique de contrôle du mélange 17 et transmis sur le poignet droit par un réseau de fibre optique. Il n'y a pas d'électronique sur le poignet, seulement un épanouissement des fibres optiques suivant la matrice classique d'affichage par point.

Le temps restant de plongée est calculé au pire : c'est le temps restant à la profondeur où l'on est à moins trente minutes avant la remontée et le palier.

### Fonction secours

Le gilet incorpore une petite bouteille d'air comprimé à 200 bars 6, d'un détendeur et d'un embout classique 2 de façon à pouvoir remonter et faire le palier de sécurité si les dispositifs électroniques sont ou semblent défaillants.

Lors de la remontée, si le dispositif électronique de remontée 22 n'est pas touché, des recommandations seront émises à l'attention du plongeur (« N'oubliez pas de souffler, ne remontez pas plus vite que ce que le remonteur vous fait faire... »).

Un son intermittent ainsi que des lumières indiqueront aux autres plongeurs que l'on effectue une remontée d'urgence.

### Bouton de remontée d'urgence

En cas de panique le plongeur peut appuyer sur un bouton type « arrêt d'urgence » 4 déclenchant une remontée d'urgence. Ce bouton est situé sur l'épaule droite et relié au réseau de fibres optiques de commande.

Dans ce cas le système de mélange va enrichir le mélange respiratoire en oxygène, le casque va s'illuminer d'une lumière apaisante et des consignes de sécurité seront données (« Ne palmez pas, restez vertical... »). Le système de remontée déclenchera une remontée rapide ; si les conditions physiologiques sont réunies (plongée pas trop profonde ou trop longue notamment) on ne fera pas de palier de sécurité.

### Option caméra ou appareil photo

L'objectif de l'appareil photo ou de la caméra 13 est disposé sur le haut du casque avec le micro. Le ou les flash(s) 27 est/sont disposé(s) sur le casque entre l'objectif et les oreilles. Cela permet de ne pas avoir une illumination directe des particules en suspension dans l'eau et donc des images plus claires. Les ondes sonores sont captées à côté de l'objectif et sont retransmises par une durite jusqu'à l'électronique de vision 3.

Le réseau de fibre optique montre dans l'intérieur du casque la zone prise en photo et les réglages seront optimisés pour des prises de vues classiques comme tous les appareils compacts actuels. L'électronique de l'appareil sera noyée dans la résine avec sa batterie rechargeable par induction.

La lumière sera transmise de l'objectif vers l'appareil photo ou la caméra par les fibres optiques. La lumière ou l'éclair du flash de même. Ces fibres ne seront pas protégées par du kevlar.

### Options guidage ou commentaires.

Ces options sont réalisées de la même manière que les fonctions « appareil photo » : récupération des informations par objectif et fibres optiques, projection dans le masque par fibres optiques, traitement dans de l'électronique noyée dans la résine et alimentation par une batterie noyée dans le même bloc de résine et rechargée par induction.

Option « guidage » : les sites de plongées sont quasiment tous connus et cartographiés. Connaissant le point de départ par GPS avant la descente, la reconnaissance optique permet de se situer et de savoir où aller suivant les principaux points d'intérêt du lieu. Lorsqu'un plongeur voit quelque chose de nouveau, la profondeur et le lieu sont connus ; si le plongeur prend cette chose en photo puis se connecte sur un site dédié, la photo et ses coordonnées vont aller se rajouter à une banque de données constamment remise à jour pour les prochains plongeurs.

Option « commentaires » : avant le départ en plongée on peut charger une base de données contenant la description de la plupart des espèces vivant à l'endroit où l'on va plonger. Pendant la plongée un détecteur de clignement d'yeux permet de déclencher le logiciel de reconnaissance optique qui affiche alors par projection dans le casque les noms et caractéristiques de l'animal ou du végétal reconnu. La reconnaissance optique fonctionne en permanence pour avertir le plongeur d'un danger potentiel. Si le logiciel reconnait un animal ou végétal dangereux il va en afficher les caractéristiques dans le casque et éventuellement déclencher un léger gonflage des sacs pour en éloigner le plongeur.

### Option GPS et appel radio du bateau

Les antennes GPS et radio 25 sont à hauteur du cou dans le casque. Les systèmes s'actionnent automatiquement lors de la sortie de l'eau (pression = pression atmosphérique du départ). Même réalisation que le reste de l'équipement électronique avec les connecteurs d'antenne noyés dans la résine comme l'électronique et la batterie.

### Références

- 1: Affichage tête haute
- 2: Embout de secours
- 3: Electronique de vision
- 4: Bouton de remontée d'urgence
- 5: Faux poumon du respirateur
- 6: Ensemble de secours
- 7: Ceinture élastique
- 8: Boucle de ceinture
- 9: Electronique, GPS, radio
- 10: Poche pour plombs
- 11: Sac d'équilibrage pour montée / descente
- 12: Electronique de photo et films
- 13: Appareil photo ou caméra
- 14: Conduite d'air pur (entrée casque)
- 15: Conduite d'air vicié (sortie casque)
- 16: Panneau d'information sur la plongée et prise de pouls
- 17: Dispositif électronique comprenant une électronique pour l'élaboration et le contrôle du mélange respirable
- 18: Bouteille d'air comprimé respirable (diluant) (200 bars)
- 19: Bouteille d'oxygène
- 20: Sac souple de chaux
- 21: Bouteille d'air comprimé pour montée / descente (20 bars)
- 22: Dispositif électronique comprenant une électronique pour la stabilisation et la montée / descente
- 23: Panneau de commande de montée / descente
- 24: Sacs gonflables pour la remontée rapide
- 25: Antenne radio et GPS
- 26: Partie vibrante pour oreilles
- 27: Flash ou torche
- 28: Partie recouverte de kevlar
- 29: Bouton Descente rapide
- 30: Bouton Montée rapide
- 31: Bouton Montée lente
- 32: Bouton Descente lente
- 33: Bouton Stabilisation
- 34: Bouton Pause
- 35: Bouton Vibrations oreilles
- 50: Dispositif électronique
- 51: Bloc de résine
- 52: Circuit électronique
- 52a: Microprocesseur
- 53: Batterie
- 54: Capteur de pression
- 55: Capteur de température
- 56a, 56b, 56c: Prises optiques
- 57a, 57b, 57c: Canalisations des compresseurs
- 100: Gilet
- 101: Casque

## Revendications

1. Dispositif pour plongeur (17, 22), comportant au moins un circuit électronique (52) et une batterie (53) prévue pour alimenter ledit circuit, ledit circuit et ladite batterie étant inclus dans un bloc de matériau hydrophobe,
**caractérisé en ce que** ledit dispositif comporte en outre au moins un actionneur inclus dans ledit bloc de matériau hydrophobe, commandé par ledit circuit électronique (52) et alimenté par ladite batterie (53), ledit actionneur comportant une vanne ou un clapet prévu pour être commandé à distance.

2. Dispositif selon la revendication 1,
**caractérisé en ce que** le bloc de matériau hydrophobe est un bloc de résine (51).

3. Dispositif selon l'une des revendications précédentes, **caractérisé en ce que** la batterie est du type à recharge sans contact électrique.

4. Dispositif selon l'une des revendications précédentes,
**caractérisé en ce que** la batterie est du type à recharge par induction.

5. Dispositif selon l'une des revendications précédentes,
**caractérisé en ce qu'**il comporte en outre un panneau de commande.

6. Dispositif selon la revendication 5,
**caractérisé en ce qu'**il comporte en outre des moyens de communication entre le circuit électronique et le panneau de commande.

7. Dispositif selon la revendication 6, **caractérisé en ce que** les moyens de communication comportent au moins un moyen d'émission/réception de signaux optiques et/ou radio et/ou d'ondes acoustiques.

8. Dispositif selon la revendication 7, **caractérisé en ce que** les moyens d'émission/réception de signaux optiques comportent au moins une prise optique (56a, 56b, 56c) prévue pour y brancher un câble à fibres optiques.

9. Dispositif selon l'une des revendications précédentes,
**caractérisé en ce qu'**il comporte en outre un capteur de pression (54) et/ou un capteur de température (55).

10. Dispositif selon l'une des revendications précédentes,
**caractérisé en ce que** ledit actionneur est un moteur entraînant un compresseur, ledit compresseur comprenant une canalisation (57a, 57b, 57c) au sein du bloc de matériau (51), le rotor dudit moteur étant logé à l'intérieur de ladite canalisation, le stator étant noyé dans ledit bloc de matériau.

11. Gilet de stabilisation (100) à air perdu pour plongeur,
**caractérisé en ce qu'**il comporte un dispositif selon l'une des revendications précédentes, relié d'une part à une bouteille de gaz de respiration et d'autre part à au moins un sac (11, 24) dudit gilet de stabilisation par des canalisations de gaz.

12. Gilet de stabilisation (100) à air recyclé pour plongeur,
**caractérisé en ce qu'**il comporte un dispositif selon l'une des revendications précédentes, relié d'une part à une bouteille de gaz pour la stabilisation (21) et d'autre part à au moins un sac (11, 24) dudit gilet de stabilisation par des canalisations de gaz.

13. Gilet de stabilisation selon l'une des revendications 11 ou 12 en ce qu'elles dépendent de la revendication 7,
**caractérisé en ce que** le panneau de commande (23) comporte un interrupteur optique (33) pour activer/désactiver une fonction Stabilisation à l'immersion atteinte du dispositif.

14. Gilet de stabilisation selon la revendication 13,
**caractérisé en ce que** ledit panneau de commande (23) comporte en outre au moins un interrupteur optique (29, 30, 31, 32, 34) pour activer/désactiver respectivement au moins l'une des fonctions suivantes du dispositif :
- Montée lente,
- Montée rapide,
- Descente lente,
- Descente rapide,
- Pause.

15. Recycleur à circuit fermé pour un plongeur,
**caractérisé en ce qu'**il comporte un dispositif selon l'une des revendications 1 à 10.

## Patentansprüche

1. Tauchvorrichtung (17, 22), umfassend zumindest eine elektronische Schaltung (52) und eine Batterie (53), die zur Stromversorgung der Schaltung vorgesehen ist, wobei die Schaltung und die Batterie in einem Block aus hydrophobem Material enthalten sind,
**dadurch gekennzeichnet, dass** die Vorrichtung ferner zumindest einen Aktuator umfasst, der in dem Block aus hydrophobem Material enthalten ist, durch die elektronische Schaltung (52) gesteuert und durch die Batterie (53) mit Strom versorgt wird, wobei der Aktuator einen Schieber oder ein Ventil hat, der oder das für eine Fernsteuerung ausgebildet ist.

2. Vorrichtung nach Anspruch 1,
**dadurch gekennzeichnet, dass** der Block aus hydrophobem Material ein Harzblock (51) ist.

3. Vorrichtung nach einem der vorhergehenden Ansprüche,
**dadurch gekennzeichnet, dass** die Batterie von der Art ist, die ohne elektrischen Kontakt aufladbar ist.

4. Vorrichtung nach einem der vorhergehenden Ansprüche,
**dadurch gekennzeichnet, dass** die Batterie von der Art ist, die durch Induktion aufladbar ist.

5. Vorrichtung nach einem der vorhergehenden Ansprüche,
**dadurch gekennzeichnet, dass** diese ferner ein Bedienfeld aufweist.

6. Vorrichtung nach Anspruch 5,
**dadurch gekennzeichnet, dass** diese ferner Mittel zur Kommunikation zwischen der elektronischen Schaltung und dem Bedienfeld umfasst.

7. Vorrichtung nach Anspruch 6,
**dadurch gekennzeichnet, dass** die Kommunikationsmittel zumindest ein Mittel zum Senden/Empfangen von optischen und/oder Funksignalen und/oder Schallwellen umfasst.

8. Vorrichtung nach Anspruch 7,
**dadurch gekennzeichnet, dass** die Mittel zum Senden/Empfangen von optischen Signalen mindestens einen optischen Anschluss (56a, 56b, 56c) zum dortigen Anschließen eines faseroptischen Kabels umfassen.

9. Vorrichtung nach einem der vorhergehenden Ansprüche,
**dadurch gekennzeichnet, dass** diese ferner einen Drucksensor (54) und/oder einen Temperatursensor (55) umfasst.

10. Vorrichtung nach einem der vorhergehenden Ansprüche,
**dadurch gekennzeichnet, dass** der Aktuator ein Motor ist, der einen Kompressor antreibt, wobei der Kompressor eine Rohrleitung (57a, 57b, 57c) in dem Materialblock (51) umfasst, wobei der Rotor des Motors im Inneren der Rohrleitung angeordnet und der Stator in dem Materialblock eingebettet ist.

11. Stabilisierungsweste (100) mit verlorener Luft für Taucher,
**dadurch gekennzeichnet, dass** diese eine Vorrichtung nach einem der vorhergehenden Ansprüche umfasst, die durch Gasleitungen einerseits mit einer Atemgasflasche und andererseits mit mindestens einer Blase (11, 24) der Stabilisierungsweste verbunden ist.

12. Stabilisierungsweste (100) mit rückgeführter Luft für Taucher,
**dadurch gekennzeichnet, dass** diese eine Vorrichtung nach einem der vorhergehenden Ansprüche umfasst, die durch Gasleitungen einerseits mit einer Gasflasche für die Stabilisierung (21) und andererseits mit mindestens einer Blase (11, 24) der Stabilisierungsweste verbunden ist.

13. Stabilisierungsweste nach einem der Ansprüche 11 oder 12, soweit abhängig von Anspruch 7,
**dadurch gekennzeichnet, dass** das Bedienfeld (23) einen optischen Schalter (33) zum Aktivieren/Deaktivieren einer Stabilisierungsfunktion bei der erreichten Eintauchtiefe der Vorrichtung aufweist.

14. Stabilisierungsweste nach Anspruch 13,
**dadurch gekennzeichnet, dass** das Bedienfeld (23) ferner mindestens einen optischen Schalter (29, 30, 31, 32, 34) aufweist, um jeweils mindestens eine der folgenden Funktionen der Vorrichtung zu aktivieren/deaktivieren:
- langsamer Aufstieg
- schneller Aufstieg
- langsamer Abstieg
- schneller Abstieg
- Pause.

15. Kreislauftauchgerät,
**dadurch gekennzeichnet, dass** dieses eine Vorrichtung nach einem der Ansprüche 1 bis 10 umfasst.

## Claims

1. Device (17, 22) for a diver, comprising at least one electronic circuit (52) and a battery (53) designed to supply said circuit, said circuit and said battery being included in a block of hydrophobic material **characterised in that** said device further comprises at least one actuator included in said block of hydrophobic material, controlled by said electronic circuit (52) and supplied by said battery (53), said actuator comprising a valve or shutter designed to be remotely controlled.

2. Device according to the claim 1,
**characterised in that** the block of hydrophobic material is a block of resin.

3. Device according to one of the preceding claims, **characterised in that** the battery is of the type that may be recharged without electrical contact.

4. Device according to one of the preceding claims **characterised in that** the battery is of the inductive-charging type.

5. Device according to one of the preceding claims **characterised in that** it further comprises a control panel.

6. Device according to claim 5,
**characterised in that** it further comprises communication means between the electronic circuit and the control panel.

7. Device according to claim 6, **characterised in that** the communication means comprise at least one means for transmitting/receiving optical and/or or radio and/or acoustic-wave signals.

8. Device according to claim 7, **characterised in that** the means of transmitting/receiving optical signals comprise at least one optical socket (56a, 56b, 56c) designed to connect an optical-fibre cable thereto.

9. Device according to one of the preceding claims,
**characterised in that** it further comprises a pressure sensor (54) and/or a temperature sensor (55).

10. Device according to one of the preceding claims,
**characterised in that** said actuator is a motor driving a compressor, said compressor comprising a duct (57a, 57b, 57c) in said block of material (51), the rotor of said motor being housed inside said duct, the stator being embedded in said block of material.

11. Lost-air stabilising jacket (100) for a diver,
**characterised in that** it comprises a device according to one of the preceding claims, connected firstly to a respiration-gas bottle and secondly to at least one bag (11, 24) on said stabilising jacket by gas ducts.

12. Recycled-air stabilising jacket (100) for a diver,
**characterised in that** it comprises a device according to one of the preceding claims, connected firstly to a gas bottle (21) for stabilisation and secondly to at least one bag (11, 24) on said stabilising jacket by gas ducts.

13. Stabilising jacket according to one of claims 11 or 12 insofar as they are dependent on claim 7,
**characterised in that** the control panel (23) comprises an optical switch (33) for activating/deactivating a stabilisation function at the expected submersion of the device.

14. Stabilising jacket according to claim 13, **characterised in that** said control panel (23) further comprises at least one optical switch (29, 30, 31, 32, 34) for activating/deactivating respectively at least one of the following functions of said device:
- slow ascent,
- rapid ascent,
- slow descent,
- rapid descent,
- pause.

15. Closed-circuit recycler for a diver, **characterised in that** it comprises a device according to one of claims 1 to 10.
